# EUROPEAN PATENT SPECIFICATION

(11) **EP 0 567 501 B1**
(45) Date of publication and mention of the grant of the patent: **12.08.1998**
(21) Application number: 92902766.2
(22) Date of filing: 14.01.1992
(51) Int. Cl.: C23C 14/34, C23C 14/08, C23C 14/50, C23C 14/56, G02B 1/10, B29D 11/00

(54) **ION VAPOUR DEPOSITION APPARATUS AND METHOD**
VORRICHTUNG UND VERFAHREN FÜR IONENDAMPFABSCHEIDUNG
APPAREIL ET PROCEDE PERMETTANT DE DEPOSER DE LA VAPEUR IONIQUE

(30) Priority: 18.01.1991 GB 9101106
(43) Date of publication of application: 03.11.1993
(73) Proprietor: APPLIED VISION LIMITED, Leeds LS6 4BA (GB); ABRAMSON, Anthony, Ian, Joseph, Leeds LS17 8BW (GB); WHITE, Norman, Henry, N. Devon EX31 4BW (GB); GALE, Derrick, Andrew, Harrogate HG1 3LF (GB)
(72) Inventor: ABRAMSON, Anthony, Ian, Joseph, Leeds LS17 8BW (GB); WHITE, Norman, Henry, Barnstaple N. Devon EX31 4BW (GB); GALE, Derrick, Andrew, Harrogate HG1 3LF (GB)
(74) Representative: Denmark, James
(86) International application number: GB9200071
(87) International publication number: WO9213114

(56) References cited:
- EP-A- 0 120 408
- DE-A- 2 100 725
- PATENT ABSTRACTS OF JAPAN vol. 11, no. 101 (C-413)(2548) 31 March 1987 & JP,A,61 250 163 ( NIPPON TELEGR AND TELEPH CORP ) 7 November 1986
- APPLIED OPTICS vol. 25, no. 16, 1 August 1986, NEW YORK USA pages 2703 - 2706; T. YAMAGUCHI ET AL.: 'INTERFACIAL OPTICAL ABSORPTION IN TIO2-SIO2 MULTILAYER COATINGS PREPARED BY RF MAGNETRON SPUTTERING.'

## Description

This invention relates to ion vapour deposition (herein IVD) by sputtering and relates to a method of and apparatus for applying coatings by IVD by sputtering.

The invention relates further to the application of coatings to articles, in particular optical lenses, and also to other articles of a width to thickness aspect ratio similar to optical lenses. The invention has particular application to optical lenses of the type used in spectacle frames, and which mainly will be corrective lenses, but could be plain lenses and in the interests of clarity reference is made hereinafter only to lenses which unless the context otherwise demands, are to be understood as being spectacle lenses.

The lenses to which the invention applies may be of glass or plastics material.

The IVD sputtering process comprises the placement of an article to be coated in a chamber in which is provided a cathode target of the coating material. Negative electric bias is applied to the target, and the chamber is filled with an inert gas, such as argon. Ionisation of the gas takes place, and the gas positive ions bombard the target by virtue of being attracted thereto due to the negative electric bias on the target. Sputtering of the target takes place which is a phenomenon resulting in the release of atoms of the target material into the chamber atmosphere. These atoms are caused to impinge upon the surface of the article to be coated and may be induced to deposit on the article by virtue of an electric bias on the article or in the region of the chamber surrounding the article, and so a coating is built up. The most usual forms of sputtering apparatus, (magnetrons), use magnetic fields in conjunction with the target material to enhance the sputtering process.

IVD processes are of course well established for many products, and are typically used for metallic products which require to be coated to a high degree of accuracy, and where the articles have to be used in controlled environments or in situations where the performance of the articles is critical. For example IVD coated articles such as screws, nuts and bolts may be used in the aircraft industry, in military applications, or in space vehicle applications. The prior devices use a target with one material attached to it. Therefore only one single material can be sputtered from the target.

The use of IVD for the coating of spectacle lenses is also known but the available machines for such coating require careful monitoring by skilled personnel; they are not in common use and generally speaking an alternative process known as evaporation is used for coating the lenses. Coatings on spectacle lenses perform several functions. Firstly, a reflection control coating serves to allow as much light of wavelength in the visible range through the lens into the eye as possible, whilst reflecting as much light which is in the harmful wavelength region, such as UV light, from the eye as possible. Other IVD coatings serve to provide a hard protective surface to protect the lenses from scratching and the like.

Generally speaking, the equipment which is used for IVD coating of lenses is evaporation equipment and is large and expensive, and requires considerable investment on the part of a processor, and in commercial terms when a person orders a pair of spectacles from an optician, the optician submits the prescription to a lens manufacturer, but the lens manufacturer in turn will pass on the lenses to the IVD coating processor who will coat the lenses as required. Coating in the conventional machine can take as much as one hour.

In the method of forming multi-layered thin films by sputtering known from JP-A-61-250163 a batch of substrates loaded on a turntable is coated. DE-A-2100725 describes a method of coating substrates where single substrates are placed in turn on a turntable and where a single substrate is coated at a time.

The present invention arises out of the objective of providing IVD coatings on batches of lenses by sputtering by means of a relatively small and inexpensive machine.

In accordance with a first aspect of the invention there is provided sputtering apparatus for applying multilayered coatings on a batch of lenses by depositing sputtered metal thereon and reacting the metal to form a coating of required composition while preventing contaminants from reaching the sputtering apparatus, said apparatus comprising a chamber and a means for creating a vacuum in said chamber, a load lock device communicating with the said chamber, said load lock device including a further means for creating a vacuum and a magazine for holding a batch of lens holders with a lens to be coated thereon, a releasable means for isolating the load lock device from the chamber, and a means for enabling each lens holder and lens to be respectively placed in a plurality of means for receiving and holding a lens holder at the periphery thereof, said plurality of holding and receiving means being on a rotatable holder in the chamber, a drive means coupled to said rotatable holder, sputtering apparatus in said chamber comprising a first magnetron having a metal target to define a metal deposition zone in the chamber when operated, a means for creating a reaction of the sputtered metal defining a reaction zone in the chamber when operated, a programmable control means arranged to cause the sputtering apparatus to operate in a programmed order.

Typically said rotatable holder is a shallow disc shape, said disc having means for receiving and holding lens holders at the periphery thereof.

Preferably, there are two of said magnetrons which have targets of different materials, and the respective magnetrons are operated alternately.

One of said targets may be silicon whilst the other may be titanium. The disc may be rotated during coating at a speed in the order of 50 revs/min.

There may be a third magnetron which is arranged to be operated as the reaction producing means to establish an oxygen plasma in the chamber during the coating operations to ensure that coatings of titanium dioxide and silicon dioxide are laid down, the chamber being supplied with oxygen at different rates depending upon whether or not the titanium target or silicon target is sputtering.

In one embodiment, the chamber is typically a cylindrical chamber of dimensions in the range 75 cm diameter, and of appropriate height.

The chamber preferably has a viewing aperture by which the IVD process being performed therein can be observed.

The or each magnetron may be of the form set forth in British Patent No 1453377 with water cooling if required provided by passages therein connected for the supply and return of cooling water.

The power source may comprise a high voltage DC or radio frequency AC supply for the charging of the target material.

Appropriate connections may be provided for the delivery and exhaust of the ionising gas and the supply of oxygen.

The disc may have peripheral notches or locations each adapted to carry a holder for holding a spectacle lens, and the disc being rotatable in the chamber so that lenses held thereby can be moved past the target materials in order to ensure that the coating material is applied evenly to the lens surface. To enhance the operation, a bias potential may be applied to the disc in order to attract the coating particles during IVD and improve adhesion.

The pre-programmable control means ensures that the load lock device after insertion of the lenses and the sealing closed of same, is evacuated until the internal pressure matches that of the treatment chamber, when the isolation means is released and the magazine of lenses is then lowered step by step into the chamber and at each step a lens and its holder are removed from the magazine and carried by the disc. When all lenses have been received on the disc, the disc is then rotated at relatively high speed, in the range of 50/60 rpm whilst the sputtering of the magnetrons to be described hereinafter takes place.

The IVD can be further enhanced by providing inside the treatment chamber a filament and cathode which are appropriately biased.

The target material magnetrons are arranged spaced and opposite in the chamber, each holding a target material, the sputtering surfaces of the materials, which surfaces are flat, being in the same plane.

The control means may comprise a crystal oscillator of which the crystal is located in the chamber adjacent the target materials to detect the rate of sputtering thereby to determine the period during which sputtering should take place to achieve the predetermined build-up of coating on the articles. The control means is programmed to cause the application of alternate, predetermined thickness layers of the target materials to the articles.

In a further aspect there is provided a method of sputter coating batches of ophthalmic lenses, the method comprising the steps of: creating a vacuum in a chamber containing a rotatable holder on which the lens are to be placed held in lens holders ; providing in said chamber at least one magnetron with a metal target for sputtering metal and a reaction producing means, loading a first batch of lenses in the lens holders into a magazine in a load lock device which is isolated from the chamber, creating a vacuum in the load lock device, connecting the load lock device with the chamber when the vacuum is achieved, placing each lens holder and lens on respective ones of a plurality of means for receiving and holding a lens holder at the periphery thereof, said plurality of means for holding and receiving being provided on the rotatable holder, until all lenses in the batch are loaded onto the holder, starting operation of the holder to continuously rotate the same, starting operation of a first magnetron whereupon at least one metal target is sputtered to cause a coating to deposit on the lenses, operating a reaction producing means during rotation of the holder to create a reaction of the metal deposited on the lenses, stopping the sputtering and the rotating of the holder when the coating on the lenses is formed, unloading the lens holders and coated lenses into the load lock device under vacuum until the batch of lenses is unloaded, isolating the device from the chamber removing the lens holders and lenses from the load lock device, wherein the process is repeated for each batch, and the forming of the coating on the lenses commences immediately upon operation of the magnetron and/or reaction producing means.

In one embodiment of the method when the first batch of lenses is removed from the load lock device, a second batch of lenses to be coated is introduced into the load lock device, a vacuum is created in the load lock device, the same is connected to the chamber when vacuum is achieved in the load lock device and the lens holders and lenses of the second batch are placed onto the holder in a batch and the operation of the sputtering and reaction means is commenced to provide a coating on the second batch of lenses and the process is repeated for as many batches as are required to be coated during operation of the apparatus and in each coating operation for each batch the sputtering application of metal to coat the lenses commences upon operation of the first magnetron.

Typically in one embodiment the second batch of lens comprises the lenses of the first batch reversed to coat a second surface of the same when placed into the chamber as a second batch.

The various constructional features enable the machine of each embodiment to provide coatings on lenses in a convenient and simple manner, and such machines can be utilised on a ,'do-it-yourself" basis by lens manufacturers which means that lenses can be manufactured for use in a shorter time, and the lens manufacturers do not have the inconvenience of having to sub-contract the coating operation. The operation is deskilled compared to the evaporation technique, and each operation can be started simply by pressing a button; the coating process stops automatically.

Embodiments of the invention will now be described, by way of example, with reference to the accompanying diagrammatic drawings, wherein:-
Fig. 1 is a sectional elevation of a machine according to an embodiment of the invention;
Fig. 2 is a perspective view showing the treatment chamber and load lock device of the machine of Fig. 1;
Fig. 3 is a plan view of the part of the apparatus shown in Fig. 2;
Fig. 4 is a perspective view showing the receiving disc which is contained in the treatment chamber, the view also illustrating the loading magazine;
Fig. 5 is a perspective view showing a part of the loading magazine and a lens holder;
Fig. 6 is a sectional elevation of the arrangement shown in Fig. 5;
Fig. 7 is a perspective view similar to Fig. 4, but showing an alternative embodiment;
Fig. 8 is a perspective view of a lens holder for use with the disc shown in Fig. 7;
Figs. 9 and 10 are sectional views of the holder shown in Fig. 8, when holding the lens concave side up and convex side up respectively; and
Fig. 11 is a sectional view of an edge of the disc of Fig. 7, with a lens holder located thereon.

Referring to the drawings, the IVD machine illustrated comprises an outer casing 10 having a partition 12 dividing the interior of the casing into a section 14 which has shelves on which are supported control units 16, 18, 20 and 22. In the other compartment 24 are contained the various operational components for effecting the drive and various displacements of the machine which will be as described hereinafter.

On the front of the machine are provided four operation buttons 26, 28, 30 and 32 whose function will be explained hereinafter, but it might be mentioned at this time that an advantage of this machine is that it is operated totally by the use of the said four buttons.

The casing 10 is of a height to enable adult persons to operate the machine in the manner to be hereinafter described.

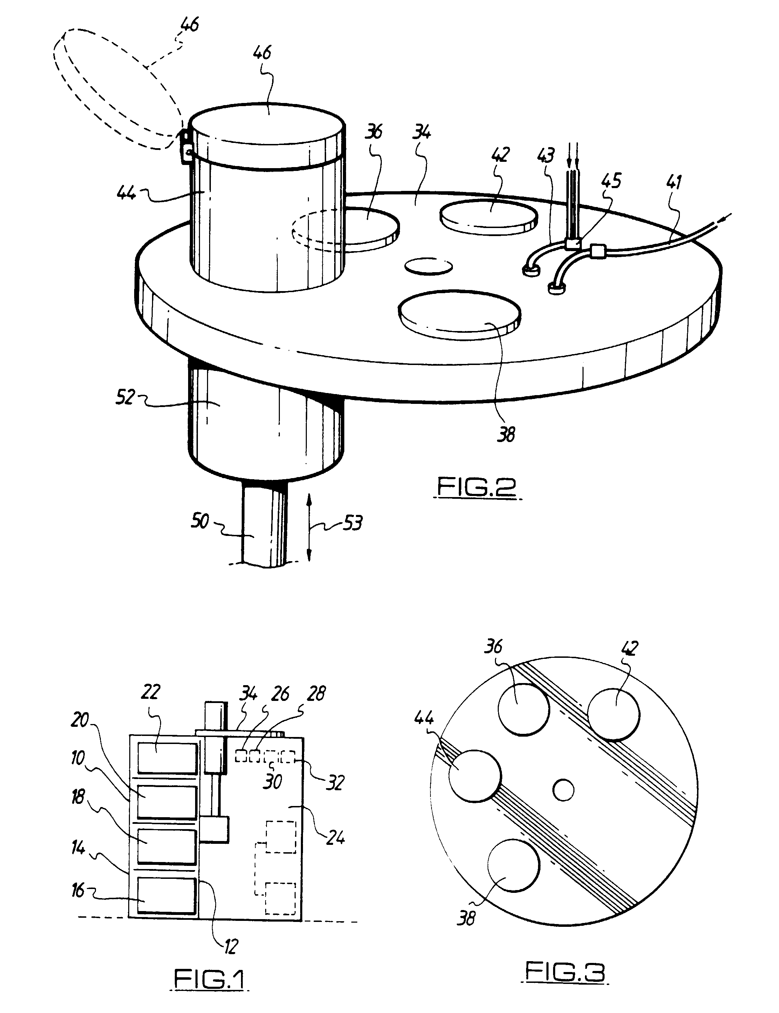

On the top of the machine is a treatment chamber 34 which is shown in enlarged detail in Fig. 2, and the chamber 34 is in the form of a narrow cylinder of diameter in the order of 75cm, and of height in the order of 20cm. The cylinder lies with its axis vertical, and on the top surface thereof are three magnetrons 36, 38 and 42 which operate typically in the manner of the sputtering apparatus described in British Patent No. 1453377 in that each is adapted to hold a target material capable of being sputtered. The magnetrons are of course connected to the control units 16 to 22 of the apparatus.

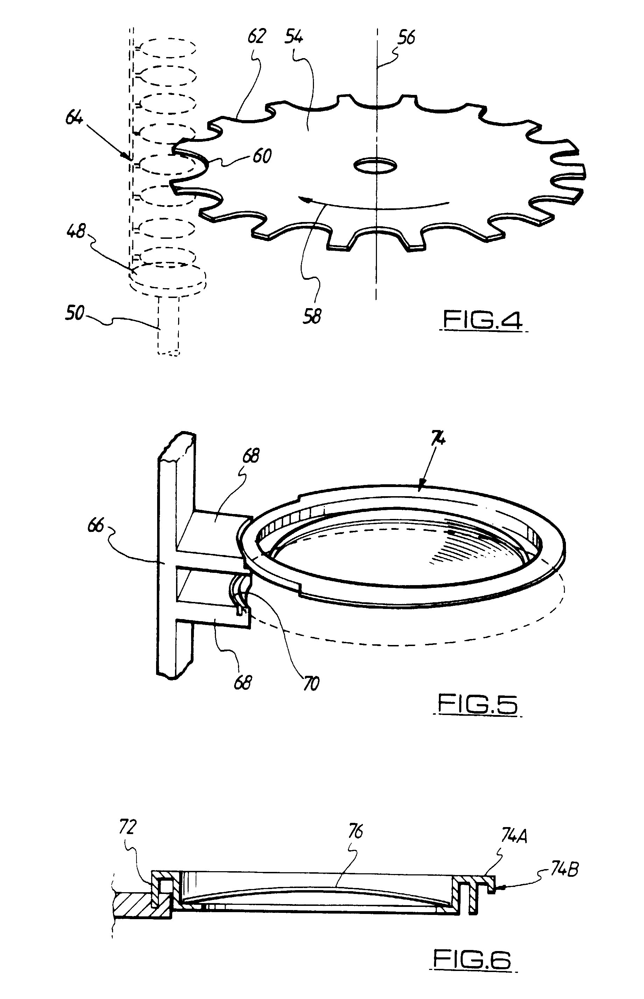

Accessing the interior of the cylinder 34 is a load lock device comprising loading chamber cylinder 44 having a lid 46 which can be opened as shown in dotted lines in Fig. 2 to permit the loading thereinto of articles to be IVD treated. The base of the loading chamber 44 is in fact defined by a sealing plate 48 which is shown in Fig. 4, so that the interior of the chamber 44 normally is isolated from the interior of the cylinder 34 when treatment is not taking place. The plate 48 is however attached to a displacement rod 50 which is moved by means of a stepping motor as will be hereinafter described so that the plate 48 is capable of being moved into a receiving chamber 52 to the underside of cylinder 34, and in alignment with the chamber 46. The possible movement of displacement rod 50 is indicated by arrow 53 in Fig. 2.

Inside the cylinder 34 and coaxial therewith is a rotatable disc 54 as shown in Fig. 4, the disc being rotatable about the axis 56 by a means not shown. The direction of rotation is indicated by arrow 58.

The disc 54 has scallops in its edge, namely a single large scallop 60 and a plurality of smaller but evenly spaced and similar sized scallops 62 which are for receiving holders each carrying a spectacle lens to be IVD treated in the cylinder 34.

As shown in Fig. 4, the sealing plate 48 has supported thereon a magazine 64 which is in the form of a post 66 as shown in Fig. 5 provided with support shelves 68. Each support shelf 68 is provided with a groove 70 in which is received a downwardly turned flange 72 of a circular lens holder 74. Fig. 6 shows the profile of the lens holder, and in fact shows a lens 76 therein. The lens it is to be noted is positioned with its convex side facing upwards i.e. towards the magnetrons 36, 38 and 42. The lens holder 74 and the magazine 64 are arranged so that the lens holders can be positioned in the scallops 62 and when positioned therein, the centre of the lens holder will travel on a pitch circle coinciding with the centres of the magnetrons 36, 38 and 42.

In order to load the machine with lenses such as lens 76 to be treated, the lenses are first placed in their holders 74, and then the holders are mounted on the mounting plates 68, and then the magazine is loaded to the loading chamber 44 in the correct position in relation to plate 48. In this connection, there will be a suitable registration means ensuring that the magazine is accurately positioned. At this time the disc 54 will be located so that the large scallop 60 is in register with the plate 48 which will in fact be above the disc plane. when the lenses have been thus positioned in the loading chamber 44, the loading operation of the machine is initiated, which as described hereinafter, comprises simply pressing an appropriate button 26-32.

After pressing of the appropriate button, operation is automatic. In the loading operation, the plate 48 is lowered by the stepping motor by a single step so that it lies under the plane of the disc 54, but so that the bottom lens holder 74 lies above the plane of the disc 54. The disc 58 is then stepped so that the first scallop 62 comes into register with the bottom holder 74 and stops. The plate 48 is then lowered by a further step which causes the holder 74 to be lifted from the support arm 68 by virtue of flange 74A seating on the portion of the disc surrounding the appropriate scallop 62, and in this connection the disc at the scallop may have a bead to engage behind the turned down edge 74B of flange 74A to retain the holder on the disc as it rotates in use. The disc steps by another pitch to bring the next scallop 62 into register with the next holder 74 on the magazine, following which the plate 48 is lowered by a further step thereby loading the next holder 74 and the lens therein onto the disc 54. The process repeats until all lens holders have been positioned on the scalloped disc, at which point the magazine will be lowered into the storage chamber 52.

The machine operates in that a vacuum is created inside the chamber of cylinder 34 by machine pumps which are similar in nature to those described in our co-pending patent application WO-A-91/05077, and an ionising gas such as argon is introduced into the chamber 34 for example through connection 41 in Fig. 2. This vacuum is maintained at all times, and the condition is indicated by the illumination of a stand-by light. The chamber 44 must be evacuated to the same pressure as inside the chamber 34, before the sealing plate 48 is lowered to connect the interior of the loading chamber 44 with the interior of the cylinder 34. In this connection there preferably is an interlock microswitch connected to the lid 46 to ensure that the sealing plate 48 is not lowered until lid 46 is moved to the closed and sealed position, and the appropriate vacuum has been created inside the chamber 44. A separate vacuum pump may be provided for evacuating chamber 44.

The depression of the button to commence the loading operation also causes continued and automatic operation of the machine, and in this connection the appropriate button 26-32 would be indicated as convex, meaning convex side upward as related to the lens position in their holders (see Fig. 6).

After the lenses have been loaded, and in accordance with the programming of the machine, the disc 54 starts to spin until it reaches a speed of 60 rpm.

When it reaches this speed, argon is introduced into the chamber 34 and after a short pause oxygen is supplied to the magnetron 42 through inlet 43 (Fig. 2). There is a further short pause to enable the pressures to stabilise and then the DC power from one of the controllers 14 to 22 is supplied to the oxygen magnetron 42. Before actuating the other magnetrons 36 and 38, the activation of the oxygen magnetron can be used for providing a plasma to provide a cleaning effect on the lenses prior to deposition of the sputtering material, this step being omitted in the inventive method.

After this operation, or immediately if no oxygen cleaning effect is required, the magnetron 36 which for example may be provided with a titanium target is switched on so that the rotating lenses are subjected to titanium dioxide deposition. The oxygen supply to magnetron 42 is set to match the material being deposited and as magnetron 38 will in the normal circumstances deposit a second metal, so the oxygen control valve 45 (Fig. 2) controlling the supply of oxygen to the magnetron 42 has to be controlled depending upon the metal being deposited. In other words the oxygen supplied to magnetron 42 must match the material being deposited.

After a pre-set time, the oxygen valve is adjusted to provide a supply suitable for the deposition of the target material from magnetron 38, and the magnetron 36 is switched off, whilst magnetron 38 is switched on and the target material therein is sputtered. Typically such target material may be silicon, which is sputtered for a pre-set time period.

As each metal is deposited on the lens, it is quickly oxidised by the oxygen plasma provided by magnetron 42 as it must be remembered that the disc 54 is being rotated at the order of 60 rpm so that the appropriate metallic oxide is formed on the lens surface. The process is repeated for third and fourth cycles as appropriate, and during each cycle different amounts of titanium dioxide and silicon dioxide may be deposited. Typically, the thinner layers of tin oxide may be created in the initial cycles and in later cycles thicker layers may be created.

Typically for coating spectacle lenses, the following non limiting example is given.
- Target materials:: titanium (magnetron 36) silicon (magnetron 38)
- Disc Speed:: Titanium Dioxide deposit: 50 rpm Silicon Dioxide deposit: 50 rpm
- Deposited each pass:: - one atomic layer
- Gas used for chamber 34.: - Argon
- 1st Stage:: Titanium dioxide deposit
- Time:: sufficient to deposit 10 mm TiO2
- 2nd Stage:: Silicon dioxide deposit
- Time:: sufficient to deposit 30 mm SiO2
- 3rd Stage:: Titanium dioxide deposit
- Time:: sufficient to deposit 110 mm T'02
- 4th Stage:: Silicon dioxide deposit
- Time:: sufficient to deposit 90 mm SiO2

When the requisite number of cycles have been completed, the apparatus automatically moves to a rest position wherein no magnetron is energised. The disc 54 seeks a home position, and the magazine 64 is progressively raised with progressive stepping of the disc 54 so that the holders 74 are re-loaded into the magazine until the plate 48 moves once again into position sealing the lower end of loading chamber 44. When this position has been reached, the lid 46 can be raised to provide access to the chamber 44 for the removal of the magazine 64 and the treated lenses. Chamber 44 may be arranged to be vented before the lid 46 can be raised, signalling the end of the coating operation. The magazine and the treated lenses are removed by hand, and the lenses are inverted and re-positioned in the magazine 64 so that the concave sides face upwards, and the magazine is re-positioned in the chamber 44 which is again closed, and the machine is operated for the treatment of the opposite sides of the lenses by the depression of one of the buttons on the front of the machine which is marked "concave" and the machine repeats these steps indicated above except that the treatment periods are adjusted accordingly because the concave surfaces of the lenses will be located a further distance from the magnetrons than the convex sides.

As to the means and method for the automatic control of the machine, reference is made to the specification WO-A-91/05077.

The machine has two DC power supplies for driving the oxygen magnetron 42 on the one hand, and the respective target material magnetrons 36 and 38 on the other hand. The power for the magnetrons 36 and 38 is much greater than that required for the magnetron 42, because in the case of the magnetron 42 it is necessary only to provide an oxygen plasma for the oxidation stage. This plasma contains 0,0₂ excited, 0₂, 0 excited, and 0 and 0₂ ions, some or all of which cause the oxidation.

It is of advantage to use a loading chamber 44 because the main cylinder 34 can be maintained at a low vacuum pressure at all times, which keeps the target materials in best condition in that the contaminants are prevented from reaching the target materials. This enables the machine to be operated in a manner requiring only depression of a start sequence button. By arranging for the chamber 34 to be maintained at a lower pressure at all times, the waiting time which would be required if the main chamber had to be evacuated for each operation, is avoided.

The vacuum loading chamber 44 will preferably be associated with the pressure gauge to ensure that the plate 48 is not moved downwards from its sealing position until the pressure inside the chamber 44 is equal to that inside chamber 34.

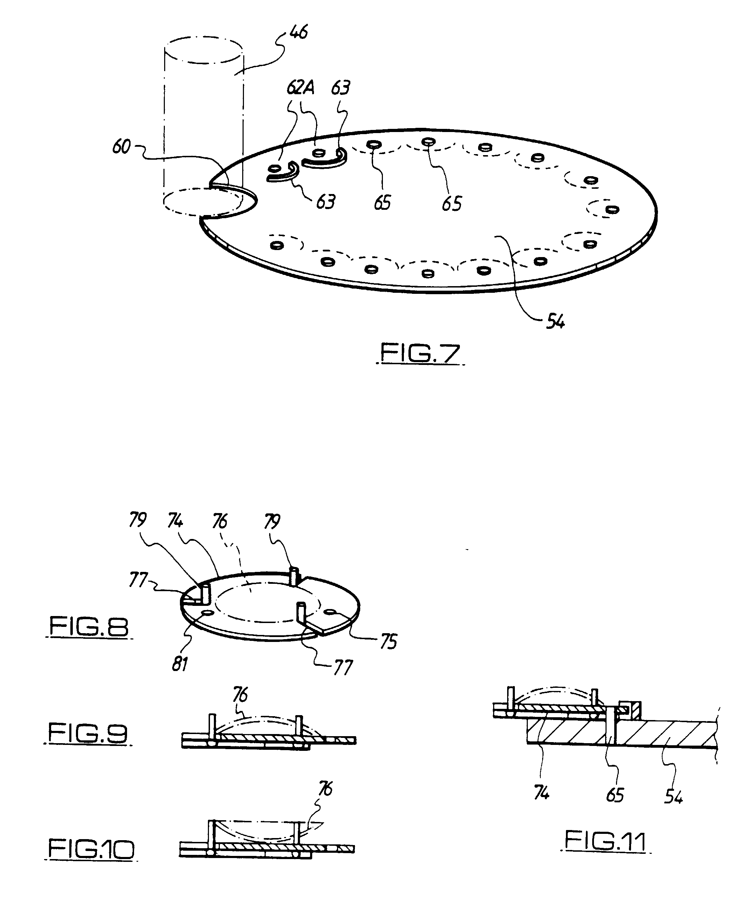

The configuration of the holders and/or disc may be varied and in one variation the lenses are held in the holders by spider type springs, the legs of which engage the edges only of the lenses to keep the lenses suspended clear of the holders, avoiding any contact with the surfaces to be coated. In another variation, the disc 54 and the holders are of the configuration shown in Figs. 7 to 11.

Referring to these figures, in Fig. 7 it will be seen that the disc 54 is provided only with the single large scallop 60, and in place of the scallop 62 are provided location zones 62A, each defined by an arcuate wall 63 and a location peg 65, arranged as shown.

The relationship of the loading cylinder 44 with the disc 54 is as described in relation to Fig. 4, and the loading procedure is similar, but the holders 74 in the Figs. 8 to 11 arrangement comprise essentially flat metal discs. Each disc 74 has a registration hole 75 for receipt of an appropriate location pin 65 when the holder is positioned on the disc, and additionally, the holder plate 74 is provided with three equiangularly spaced slots 77 in which are located lens retention pins 79 which are adjustable radially relative to the holder plate 74, by means not shown. Such means may comprise for example a screw threaded bar located to the underside of the plate 74. These pins serve to hold a lens 76 which is positioned on the holder plate 74 for receiving the treatment hereinbefore described.

Finally the plate 74 has means enabling it to be engaged by and held by the support arm 68 of the magazine loading mechanism. Such means may comprise apertures 81 for receiving appropriate pins on the arm 68.

Figs. 9 and 10 show that the lens 76 can be placed convex side upwards or concave side upwards to enable both sides of the lens to be treated as hereinbefore described.

The advantage of using a flat plate as described with radially adjustable holding pin 79 is that the lens is not located in a well or recess as it is in the arrangement of Fig. 6. It has been found that by providing a holder as shown in Fig. 6, it sometimes happens that the peripheral edge region of the lens surface remains untreated following the treatment operation, because the wall of the cavity or recess acts as a shadow preventing impingement on the peripheral edge of the lens of the coating material. This would also not take place when the spider springs as described hereinbefore are used.

Secondly, by the alternative arrangements described it is possible to grip and hold lenses which are of a non-circular shape and plan view. In other words it is possible to treat the lenses after they have been shaped to fit specific spectacle frames.

The loading and treatment operation are essentially as described in relation to the previous figures, although Fig. 11 does show how a holder plate 74 is received on the disc 54 at an appropriate location 62A. The location pin 65 locates in the receiving aperture 75, and the arcuate wall 63 is neatly shaped to the edge of the plate 74 so that when the disc 54 is rotated at the relatively high speed of 60 rpm, the holders 74 remain securely in position, and when rotation of the disc has terminated and the holders 74 are removed from plate 54, the pins on the magazine mechanism arm 68 will accurately engage in holes 81 and lift the individual holder plates from the disc 54.

Reference has been made hereinbefore to the use of titanium and silicon targets, but it is to be mentioned that targets of any suitable materials such as tantalum, indium, tin, gold and mixtures of these may be used.

Also, although the description hereinbefore suggests that the target materials are sputtered alternately, it is possible in some arrangements to provide for simultaneous sputtering of targets of different materials.

The oxygen may be supplied to the oxygen magnetron 42 through either of two valves for the achievement of different partial pressures of the oxygen depending upon the materials being sputtered. A gas flow controller may be fitted to ensure the automatic supply of oxygen as related to the material being sputtered.

The oxygen magnetron 42 in fact uses a target of titanium or carbon or the like driven at a low power as its purpose simply is to create a plasma of oxygen for providing the oxidation referred to herein.

The chamber 34 may be provided with a viewing window whereby the IVD process going on inside the chamber can be viewed. Such a viewing window may not be necessary especially when the process is carried out under automatic control, or if the chamber is constructed from glass, which is a possible embodiment of the invention.

There may be provided within the chamber an electron source in the form of a hot wire filament with a positively biased probe. The use of this filament and probe can raise the ionization efficiency of the system.

As set forth in said PCT application, the chamber 34 may be evacuated using a turbo molecular pump in series with a rotary pump.

Each magnetron may be as disclosed in said PCT application, and/or as disclosed in British Patent 1,453,377, except that the target material faces downwardly into the chamber 34.

Argon is the gas mainly used for the chamber to create the discharge and sputtering. However, for reactive coating, argon reactive gas mixtures are used to provide the required reaction.

It will be appreciated that appropriate electrical insulation will be provided in order to ensure the electrical effects. For example the drive shaft which rotates the disc 54 will be appropriately insulated.

As described in said PCT application, the control of the time period during which sputtering and deposition is taking place in relation to the respective targets, may be pre-programmed and then controlled automatically for example by utilisation of an oscillator to monitor the sputtering rate. Indeed, any of the features disclosed in said PCT application may be used in conjunction with the embodiment of the present invention.

As in the invention disclosed in said PCT application, the embodiment of the present invention has many advantages including but not limited to the following:-
1. Uniform and adherent multi-layered anti-reflection coatings can be deposited on both sides of glass or plastic lenses.
2. Many thin layers can be deposited without interrupting the process.
3 By using thermionically assisted triode discharge it is possible to operate at low gas base pressure thus making the process more efficient and less expensive in terms of gas consumption.
4. It is possible to control independently the lens holder bias, gas pressure, reactive gasses pressure and discharge current density.
5. Different reactive gases could be employed to deposit various layers including "hard diamond" coating which is a carbon coating having a hardness similar to that of diamond.
6. Dense coating can be achieved by increasing the ionisation efficiency and lowering the gas pressure.
7. Metals, semi-conductors and insulators could be sputtered using the process.
8. A uniform coating is created on a non uniform shape i.e. curved lens.

## Claims

1. Sputtering apparatus for applying multilayered coatings on a batch of lenses (76) by depositing sputtered metal thereon and reacting the metal to form a coating of required composition while preventing contaminants from reaching the sputtering apparatus, said apparatus comprising a chamber (34) and a means for creating a vacuum in said chamber, a load lock device (44, 46, 48, 50, 64) communicating with the said chamber, said load lock device including a further means for creating a vacuum and a magazine (64) for holding a batch of lens holders (74) with a lens (76) to be coated thereon, a releasable means (48) for isolating the load lock device from the chamber, and a means for enabling each lens holder and lens to be respectively placed in a plurality of means (62) for receiving and holding a lens holder (74) at the periphery thereof, said plurality of holding and receiving means (62) being on a rotatable holder (54) in the chamber (34), a drive means coupled to said rotatable holder, sputtering apparatus in said chamber comprising a first magnetron (36, 38) having a metal target to define a metal deposition zone in the chamber when operated, a means (42) for creating a reaction of the sputtered metal defining a reaction zone in the chamber when operated, a programmable control means arranged to cause the sputtering apparatus to operate in a programmed order.

2. Apparatus according to Claim 1 characterised in that the sputtering apparatus comprises at least two magnetrons (36, 38), a first magnetron (36) having a target of a first metal and a second magnetron (38) having a target of a second metal to create a multilayered coating containing more than one metal.

3. Apparatus according to Claim 1 characterised in that the reaction producing means (42) is an unbalanced magnetron which, when operated, establishes a plasma in said chamber.

4. A method of sputter coating batches of ophthalmic lenses, the method comprising the steps of: creating a vacuum in a chamber (34) containing a rotatable holder (54) on which the lens (76) are to be placed held in lens holders (74); providing in said chamber (34) at least one magnetron (36, 38) with a metal target for sputtering metal and a reaction producing means (42), loading a first batch of lenses (76) in the lens holders (74) into a magazine (64) in a load lock device (44, 46, 48, 50, 64) which is isolated from the chamber (34), creating a vacuum in the load lock device, (44, 46, 48, 50, 64), connecting the load lock device (44, 46, 48, 50, 64) with the chamber (34) when the vacuum is achieved, placing each lens holder (74) and lens (76) on respective ones of a plurality of means (62) for receiving and holding a lens holder (74) at the periphery thereof, said plurality of means for holding and receiving being provided on the rotatable holder (54) until all lenses in the batch are loaded onto the holder (54), starting operation of the holder (54) to continuously rotate the same, starting operation of a first magnetron (36, 38) whereupon at least one metal target is sputtered to cause a coating to deposit on the lenses (76), operating a reaction producing means (34, 36) during rotation of the holder (54) to create a reaction of the metal deposited on the lenses (76), stopping the sputtering and the rotating of the holder (54) when the coating on the lenses (76) is formed, unloading the lens holders (74) and coated lenses into the load lock device (44, 46, 48, 50, 64) under vacuum until the batch of lens is unloaded, isolating the device from the chamber, removing the lens holders (74) and lenses (76) from the load lock device, wherein the process is repeated for each batch, and the forming of the coating on the lenses (76) commences immediately upon operation of the magnetron and/or reaction producing means.

5. A method according to Claim 4 characterised in that when the first batch of lenses (76) is removed from the load lock device (44, 46, 48, 50, 64), a second batch of lenses (76) to be coated is introduced into the load lock device, a vacuum is created in the load lock device, the same is connected to the chamber (34) when vacuum is achieved in the load lock device and the lens holders (74) and lenses (76) of the second batch are placed onto the holder (54) in a batch and the operation of the sputtering and reaction means is commenced to provide a coating on the second batch of lenses and the process is repeated for as many batches as are required to be coated during operation of the apparatus and in each coating operation for each batch the sputtering application of metal to coat the lenses (76) commences upon operation of the said first magnetron (36, 38).

6. A method according to Claim 5 characterised in that the second batch of lenses comprises the lenses (76) of the first batch reversed to coat a second surface of the same when placed into the chamber (34) as a second batch.

## Patentansprüche

1. Zerstäubungsvorrichtung zum Aufbringen mehrschichtiger Überzüge auf eine Serie von Linsen (76) durch Aufdampfen von zerstäubtem Metall auf diese und Reagieren des Metalls zur Bildung eines Überzugs der gewünschten Zusammensetzung, während verhütet wird, daß Verunreinigungen die Zerstäubungsvorrichtung erreichen, wobei die genannte Vorrichtung folgendes umfaßt: eine Kammer (34) und ein Mittel zum Erzeugen eines Vakuums in der genannten Kammer, eine Ladeschleuse (44, 46, 48, 50, 64), die mit der genannten Kammer in Verbindung steht, wobei die genannte Ladeschleuse ferner ein Mittel zum Erzeugen eines Vakuums und ein Magazin (64) zum Halten einer Serie von Linsenhaltern (74) mit einer zu beschichtenden Linse (76) darauf beinhaltet, ein lösbares Mittel (48) zum Trennen der Ladeschleuse von der Kammer, und ein Mittel, mit dem jeder Linsenhalter und jede Linse jeweils in eine Mehrzahl von Mitteln (62) zum Aufnehmen und Halten eines Linsenhalters (74) an dessen Umfang gesetzt werden kann, wobei sich die genannte Mehrzahl von Halte- und Aufnahmemitteln (62) auf einem drehbaren Halter (54) in der Kammer (34) befindet, ein Antriebsmittel, das mit dem genannten drehbaren Halter gekoppelt ist, wobei die Zerstäubungsvorrichtung in der genannten Kammer folgendes umfaßt: ein erstes Magnetron (36, 38) mit einem Metalltarget, um während des Betriebs eine Metallaufdampfungszone in der Kammer zu definieren, ein Mittel (42) zum Erzeugen einer Reaktion des zerstäubten Metalls, das beim Betrieb eine Reaktionszone in der Kammer definiert, ein programmierbares Steuermittel, das bewirkt, daß die Zerstäubungsvorrichtung in einer programmierten Reihenfolge arbeitet.

2. Vorrichtung nach Anspruch 1, dadurch gekennzeichnet, daß die Zerstäubungsvorrichtung wenigstens zwei Magnetrons (36, 38) umfaßt, wobei ein erstes Magnetron (36) ein Target aus einem ersten Metall und ein zweites Magnetron (38) ein Target aus einem zweiten Metall aufweist, um einen mehrschichtigen Überzug zu erzeugen, der mehr als ein Metall enthält.

3. Vorrichtung nach Anspruch 1, dadurch gekennzeichnet, daß das Reaktionserzeugungsmittel (42) ein unsymmetrisches Magnetron ist, das beim Betrieb ein Plasma in der genannten Kammer erzeugt.

4. Verfahren zum Aufstäubungsbeschichten von Serien von optischen Linsen, wobei das Verfahren die folgenden Schritte umfaßt: Erzeugen eines Vakuums in einer Kammer (34), die einen drehbaren Halter (54) enthält, auf den die in Linsenhaltern (74) gehaltenen Linsen (76) gesetzt werden; Bereitstellen von wenigstens einem Magnetron (36, 38) mit einem Metalltarget zum Aufstäuben von Metall und einem Reaktionserzeugungsmittel (42) in der genannten Kammer (34), Laden einer ersten Serie von Linsen (76) in den Linsenhaltern (74) in ein Magazin (64) in einer Ladeschleuse (44, 46, 48, 50, 64), die von der Kammer (34) getrennt ist, Erzeugen eines Vakuums in der Ladeschleuse (44, 46, 48, 50, 64), Verbinden der Ladeschleuse (44, 46, 48, 50, 64) mit der Kammer (34), wenn das Vakuum erreicht ist, Plazieren jedes Linsenhalters (74) mit Linse (76) auf jeweilige aus einer Mehrzahl von Mitteln (62) zum Aufnehmen und Halten eines Linsenhalters (74) um den Umfang, wobei die genannte Mehrzahl von Mitteln zum Halten und Aufnehmen so lange auf dem drehbaren Halter (54) bereitgestellt wird, bis alle Linsen in der Serie auf den Halter (54) geladen sind, Inbetriebsetzen des Halters (54), um diesen kontinuierlich zu drehen, Inbetriebsetzen eines ersten Magnetrons (36, 38), wonach wenigstens ein Metalltarget aufgestäubt wird, um das Aufdampfen eines Überzugs auf den Linsen (76) zu bewirken, Betätigen eines Reaktionserzeugungsmittels (34, 36) während der Rotation des Halters (54), um eine Reaktion des auf die Linsen (76) aufgedampften Metalls zu erzeugen, Stoppen des Aufstäubens und des Drehens des Halters (54), wenn der Überzug auf den Linsen (76) gebildet ist, Entladen der Linsenhalter (74) und der beschichteten Linsen in die Ladeschleuse (44, 46, 48, 50, 64) unter Vakuum, bis die Serie von Linsen entladen ist, Trennen der Schleuse von der Kammer, Herausnehmen der Linsenhalter (74) und Linsen (76) aus der Ladeschleuse, wobei der Vorgang für jede Serie wiederholt wird und das Bilden des Überzuges auf den Linsen (76) unmittelbar nach der Inbetriebsetzung des Magnetrons und/oder des Reaktionserzeugungsmittels beginnt.

5. Verfahren nach Anspruch 4, gekennzeichnet durch die folgenden Schritte: wenn die erste Serie von Linsen (76) aus der Ladeschleuse (44, 46, 48, 50, 64) herausgenommen ist, wird eine zweite Serie von zu beschichtenden Linsen (76) in die Ladeschleuse eingelegt, Vakuum wird in der Ladeschleuse erzeugt, dieselbe wird mit der Kammer (34) verbunden, wenn Vakuum in der Ladeschleuse erreicht ist, und die Linsenhalter (74) und Linsen (76) der zweiten Serie werden auf den Halter (54) in einer Serie gelegt, und das Aufstäubungs- und Reaktionsmittel wird in Betrieb gesetzt, um einen Überzug auf der zweiten Serie von Linsen zu erzeugen, und der Vorgang wird für so viele Serien wiederholt, wie während des Betriebs der Vorrichtung beschichtet werden müssen, und bei jedem Beschichtungsvorgang für jede Serie beginnt das Aufstäuben von Metall zum Beschichten der Linsen (76) nach der Inbetriebsetzung des genannten ersten Magnetrons (36, 38).

6. Verfahren nach Anspruch 5, dadurch gekennzeichnet, daß die zweite Serie von Linsen das Umdrehen der Linsen (76) der ersten Serie umfaßt, um eine zweite Oberfläche derselben zu beschichten, wenn sie als zweite Serie in die Kammer (34) gelegt werden.

## Revendications

1. Un équipement de pulvérisation pour appliquer des enductions multi-couches sur un lot de lentilles (76) par le dépôt, sur celles-ci, d'un métal en pulvérisation et par la réaction du métal de façon à former une couche de la composition requise, tout en empêchant les contaminants de parvenir à l'appareil de pulvérisation, ledit appareil comprenant une chambre (34), et un moyen destiné à créer un vide dans ladite chambre, un dispositif de verrouillage de charge (44, 46, 48, 50, 64) communiquant avec ladite chambre, ledit dispositif de verrouillage de charge comportant un moyen supplémentaire permettant de créer un vide ainsi qu'un magasin (64) pour soutenir un lot de supports de lentille (74) avec une lentille, destinée à être enduite, placée sur ceux-ci, un moyen de déblocage (48) pour isoler le dispositif de verrouillage de charge par rapport à la chambre, et un moyen permettant à chaque support de lentille et à chaque lentille d'être placés respectivement dans une pluralité de moyens (62) conçus pour recevoir et soutenir un support de lentille (74) sur la périphérie de ceux-ci, ladite pluralité de moyens de support et de réception (62) se trouvant sur un support rotatif (54) dans la chambre (34), un moyen d'entraînement accouplé audit support rotatif, l'appareil de pulvérisation dans ladite chambre comprenant un premier magnétron (36, 38) ayant une cible métal pour définir la zone de dépôt de métal dans la chambre une fois qu'il est en fonctionnement, un moyen (42) destiné à amorcer une réaction du métal pulvérisé définissant une zone de réaction dans la chambre lors de son fonctionnement, un moyen de commande programmable agencé de manière à obliger l'appareil de pulvérisation à fonctionner selon une séquence programmée.

2. Un appareil, selon les stipulations de la revendication 1, caractérisé en ce que l'appareil de pulvérisation comprend au moins deux magnétrons (36, 38), un premier magnétron (36) ayant pour cible un premier métal et un deuxième magnétron (38) ayant pour cible un deuxième métal afin de créer une enduction multi-couches contenant plusieurs métaux.

3. Un appareil, selon les stipulations de la revendication 1, caractérisé en ce que le moyen de production de réaction (42) est un magnétron en déséquilibre qui, lors de son fonctionnement, produit un plasma dans ladite chambre.

4. Une méthode d'enduction par pulvérisation de lentilles ophtalmiques, la méthode comprenant les étapes suivantes : création d'un vide dans la chambre (34) comportant un support rotatif (54) sur lequel les lentilles (76) contenues dans les supports de lentille (74) sont destinées à être placées ; utilisation, dans ladite chambre (34) d'au moins un magnétron (36, 38) avec une cible métal pour pulvériser le métal et un moyen de production de réaction (42) ; chargement d'un premier lot de lentilles (76) placé sur les supports de lentille (74) pour les mettre dans un magasin (64) dans un dispositif de verrouillage de charge (44, 46, 48, 50, 64) qui est isolé de la chambre (34) ; création d'un vide dans le dispositif de verrouillage de charge (44, 46, 48, 50, 64) ; connexion du dispositif de verrouillage de charge (44, 46, 48, 50, 64) avec la chambre (34) une fois que le vide est obtenu ; positionnement de chaque support de lentille (74) et lentille (76) sur les moyens respectifs d'une pluralité de moyens (62) destinés à recevoir et à soutenir un support de lentille (74) à la périphérie de ceux-ci, ladite pluralité de moyens pour le soutien et la réception étant prévus sur le support rotatif (54) jusqu'à ce que toutes les lentilles du lot aient été chargées sur le support (54) ; démarrage du fonctionnement du support (54) pour faire tourner ce dernier en permanence ; démarrage du fonctionnement du premier magnétron (36, 38) après quoi une cible métal au moins est pulvérisée, pour obliger une enduction de se déposer sur les lentilles (76) ; amorçage d'un moyen de production de réaction (34, 36) pendant la rotation du support (54) afin de créer une réaction du métal déposé sur les lentilles (76) ; arrêt de la pulvérisation et de la rotation du support (54) lorsque l'enduction des lentilles (76) est formée ; évacuation des supports de lentille (74) et des lentilles enduites vers le dispositif de verrouillage de charge (44, 46, 48, 50, 64) sous vide jusqu'à ce que le lot de lentilles soit déchargé ; isolation du dispositif par rapport à la chambre ; enlèvement des supports de lentille (74) et des lentilles (76) du dispositif de verrouillage de charge ; dans laquelle le processus est répété pour chaque lot, et la formation de la couche d'enduction sur les lentilles (76) commence immédiatement après le fonctionnement du magnétron et/ou du moyen de production de réaction.

5. Une méthode, selon les stipulations de la revendication 4, caractérisée en ce que, lorsque le premier lot de lentilles (76) est enlevé du dispositif de verrouillage de charge (44, 46, 48, 50, 64), un deuxième lot de lentilles (76) à enduire est introduit dans le dispositif de verrouillage de charge, un vide est créé dans le dispositif de verrouillage de charge, celui-ci est relié à la chambre (34) lorsque le vide est fait dans le dispositif de verrouillage de charge et les supports de lentille (74) et les lentilles (76) du deuxième lot sont placées sur le support (54) en un lot, et le fonctionnement du moyen de pulvérisation et de réaction est amorcé, afin d'assurer l'enduction du deuxième lot de lentilles, et le processus est répété sur autant de lots qui ont besoin d'être enduits pendant le fonctionnement de l'appareil, et lors de chaque opération d'enduction de chaque lot, l'application par pulvérisation de métal, destinée à enduire les lentilles (76), commence au moment où ledit premier magnétron (36, 38) se met en marche.

6. Une méthode, selon les stipulations de la revendication 5, caractérisée en ce que le deuxième lot de lentilles comprend les lentilles (76) du premier lot, à l'état inversé, afin d'effectuer l'enduction d'une deuxième surface de ces dernières lorsqu'elles sont placées dans la chambre (34) en tant que deuxième lot.
